# EUROPÄISCHE PATENTANMELDUNG

(11) **EP 1 187 331 A1**
(43) Veröffentlichungstag der Anmeldung: **13.03.2002**
(21) Anmeldenummer: 00119282.2
(22) Anmeldetag: 06.09.2000
(51) Int. Cl.: H03K 5/13

(54) **Verzögerungsglied**

(71) Anmelder: Infineon Technologies AG, 81669 München (DE)
(72) Erfinder: Schlager, Tobias, 8062 Kumberg (AT); Kupnik, Mario, 8700 Leoben (AT)
(74) Vertreter: Hermann, Uwe, Dipl.-Ing.

(57) **Zusammenfassung**

Die Erfindung betrifft ein Verzögerungsglied mit mindestens einem elektronischen Schalter (5, 6), an dessen Eingang (1) ein Eingangssignal (4) und an dessen Ausgang (2) ein Ausgangssignal (7) anliegt und einer Strombegrenzungsvorrichtung (N4, N5), die die Stromaufnahme des mindestens einen elektronichen Schalters (5, 6) begrenzt, wobei durch die Begrenzung der Stromaufnahme des mindestens einen elektronischen Schalters (5, 6) die Schaltzeit verlangsamt ist. Durch die Begrenzung der Stromaufnahme auf einen sehr kleinen Wert wird die Schaltzeit des mindestens einen elektronischen Schalters (5, 6) so verlangsamt daß eine Verzögerungszeit entsteht, die dem Grenzwert des Stromes proportional ist. Im Vergleich zu Verzögerungsgliedern mit Kondensatoren ergibt sich ein sehr geringer Stromverbrauch.

## Beschreibung

Die Erfindung betrifft ein Verzögerungsglied zum Einsatz in elektronischen Ansteuerschaltungen.

Verzögerungsglieder bewirken, daß ein an ihrem Eingang anliegendes Signal am Ausgang um eine definierte Zeit verzögert ausgegeben wird. Auf diese Weise ist es beispielsweise möglich, aus einem Impuls zwei oder mehrere verzögert folgende Impulse zu formen. Eine übliche Maßnahme zur Verzögerung von digitalen Signalen ist, den Signalanstieg durch den Einsatz eines Kondensators zu verlangsamen. Ein damit verbundenes digitales Schaltglied schaltet erst dann, wenn eine definierte Spannung an dem Kondensator überschritten wird. Da der Ladevorgang Zeit benötigt, wird dieser Spannungswert erst verspätet und man erhält eine Verzögerung des Signales. Die Verzögerungszeit wird durch die Größe des Kondensators bestimmt.

Zur Ladung des Kondensators ist jedoch ein relativ großer Ladestrom notwendig. In Anwendungsfällen, bei denen auf eine Batteriestromversorgung zurückgegriffen wird, oder beispielsweise bei einer kontaktlosen Chipkarte ist jedoch die Reduzierung des Stromverbrauchs ein wesentliches Ziel. Außerdem besteht vielfach der Wunsch, die Verzögerungszeit eines Verzögerungsgliedes einstellen zu können, was bei Verwendung von Kondensatoren nicht möglich ist.

Aufgabe der Erfindung ist es daher, ein Verzögerungsglied anzugeben, das eine reduzierte Stromaufnahme aufweist und zudem die Möglichkeit der Einstellung der Verzögerungszeit enthält.

Dieses Ziel wird erfindungsgemäß durch ein Verzögerungsglied gelöst mit mindestens einem elektronischen Schalter, an dessen Eingang ein Eingangssignal und an dessen Ausgang ein Ausgangssignal anliegt, und eine Strombegrenzungsvorrichtung, die die Stromaufnahme des elektronischen Schalters begrenzt, wobei durch die Begrenzung der Stromaufnahme des elektronischen Schalters die Schaltzeit verlangsamt ist.

Der Vorteil dieser Anordnung besteht darin, daß kein Ladestrom für nicht parasitäre Kondensatoren vorgesehen werden muß. Vielmehr wird die Stromaufnahme des elektronischen Schalters so stark begrenzt, daß er verhältnismäßig viel Zeit benötigt, um die zum Schalten notwendigen Ladungsverschiebungen vorzunehmen.

In einer vorteilhaften Ausführung wird die Strombegrenzungsvorrichtung durch einen Stromspiegel realisiert. Der Referenzzweig des Stromspiegels kann an eine stabilisierte Referenzspannung angelegt sein, so daß eine konstante Verzögerungszeit gewährleistet ist. Da die Verzögerungszeit durch die Strombegrenzungsvorrichtung bestimmt ist, ist eine Einstellbarkeit vereinfacht.

In einer weiteren vorteilhaften Ausführung wird die Strombegrenzungsvorrichtung durch einen Zufallsgenerator angesteuert. Durch eine solche Maßnahme ist eine Analyse der internen Vorgänge einer Chipkarte durch Messung des Stromverbrauchs der auf der Chipkarte befindlichen integrierten Schaltung verhindert oder zumindest erschwert.

Weitere Vorteile und Ausgestaltungen der Erfindung sind in den Unteransprüchen angegeben.

Die Erfindung wird nachfolgend anhand eines Ausführungsbeispieles näher erläutert. Es zeigt:
- Figur 1: ein Verzögerungsglied gemäß der Erfindung,
- Figur 2: eine Anordnung von zwei Verzögerungsgliedern nach Figur 1 bei Verwendung verschiedener Logikpegel und
- Figur 3: eine Speicher-Ansteuerschaltung bei Einsatz der Verzögerungsglieder von Figur 1.

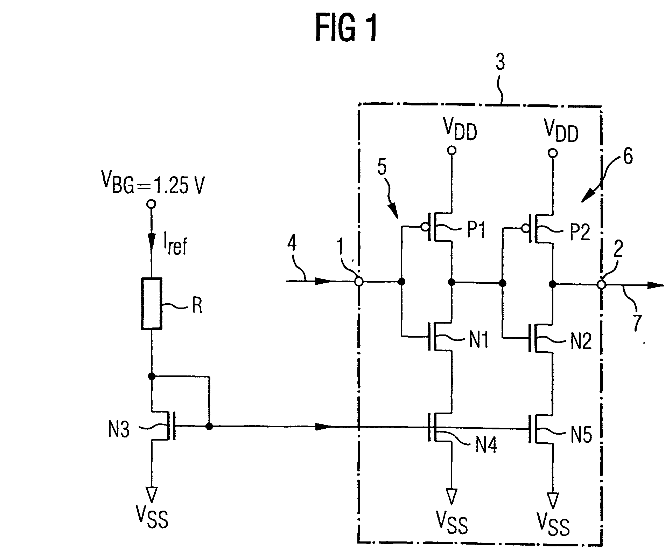

In der Figur 1 wird ein Verzögerungsglied 3 mit zwei Invertern 5 und 6, die elektronische Schalter darstellen, realisiert. Jeder der Inverter 5 und 6 ist dabei durch einen PMOS-Transistor P1 beziehungsweise P2 und einen NMOS-Transistor N1 beziehungsweise N2 realisiert. Die Source-Drain-Strecken sind in Reihe geschaltet. Die Transistoren P1 und P2 sind mit der Versorgungsspannung verbunden. Ein Eingangssignal 4 liegt an den Gates der Transistoren P1 und N1 an, die somit einen Eingang des Verzögerungsgliedes 3 bilden. Zwischen den Transistor N1 und das Bezugspotential V_{SS} ist ein weiterer NMOS-Transistor N4 geschaltet. Bei dem zweiten Inverter 6 liegt entsprechend ein Transistor N5 zwischen dem Transistor N2 und dem Bezugspotential V_{SS}. Durch Ansteuerung der Transistoren N4 und N5 ist der Stromfluß durch die Inverter 5 und 6 steuerbar. Die Transistoren N4 und N5 stellen daher Strombegrenzungsvorrichtungen dar. Der Strom durch die Transistoren N4 und N5 wird auf sehr kleine Werte eingestellt, beispielsweise auf 300 nA. Dadurch ergibt sich für ein Verzögerungsglied 3 gemäß der Figur 1 eine Verzögerungszeit von in der Größenordnung von 10 ns.

Die Höhe des Stromflusses durch die Transistoren N4 und N5 wird in vorteilhafter Weise durch einen Stromspiegel eingestellt. Ein Referenzzweig weist einen Widerstand R und einen NMOS-Transistor N3 auf, wobei der Widerstand R mit einer Spannungsquelle V_{BG} verbunden ist. Der Drain-Anschluß und der Gate-Anschluß des Transistors N3 sowie die Gate-Anschlüsse der Transistoren N3, N4 und N5 sind miteinander verbunden. Durch eine derartige Anordnung stellt sich auf den Drain-Source-Strecken der Transistoren N4 und N5 ein Strom ein, der proportional zu dem Strom durch den Transistor N3 ist.

Die Versorgungsspannung ist in vielen Anwendungsfällen nicht exakt konstant, sondern ist Schwankungen unterworfen. Daher ist als Spannungsquelle V_{BG} eine Referenzspannungsquelle verwendet, die eine Spanung bereitsstellt, die zwar niedriger ist als die normale Versorgungsspannung V_{DD}, dafür aber auf einen exakten Wert festgelegt ist. In diesem Ausführungsbeispiel, das für den Einsatz in kontaktlosen Chipkarten konzipiert ist, beträgt die Spannung V_{BG} 1,25 V. Diese Referenzspanung ist auf kontaktlosen Chipkarten ohnehin vorhanden. Dadurch ist sichergestellt, daß die Verzögerungszeit des Verzögerungsgliedes immer ΔT = 10 ns beträgt. Schwankungen der Versorgungsspannung V_{DD} haben so keinen Einfluß auf die Verzögerungszeit.

Im vorliegenden Anwendungsfall soll nur die ansteigende Flanke eines Impulses genutzt werden. Daher genügt es, den Strom der Inverter 5 und 6 hin zu dem Bezugspotential V_{SS} zu begrenzen. In einem anderen Anwendungsfall, in dem auch die abfallende Flanke genutzt werden soll, muß auch zur Versorgungsspannung V_{DD} begrenzt werden.

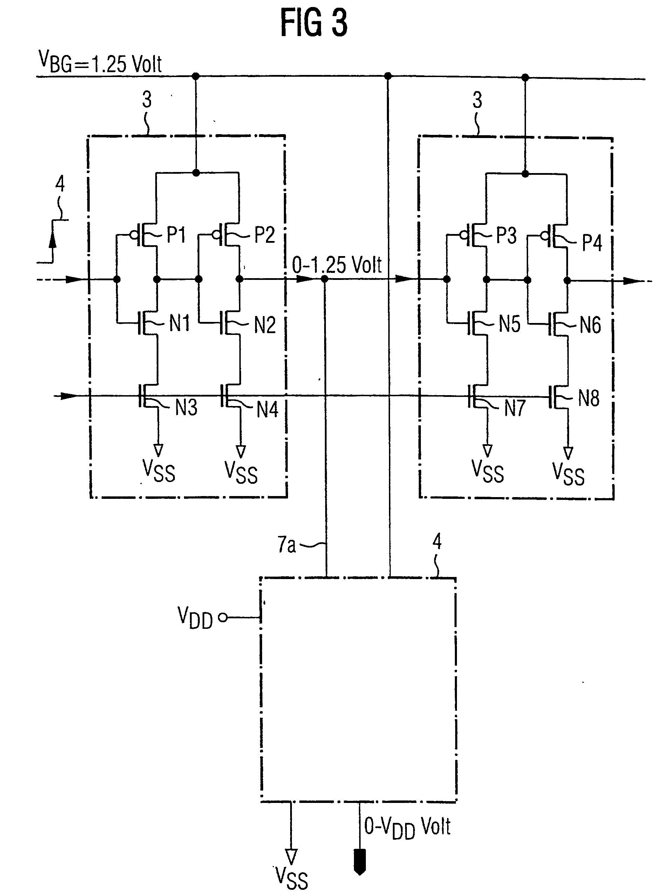

Mit mehreren solchen Verzögerungsgliedern 3 ist eine Verzögerungsleitung 10 aufbaubar. Mit einem Impuls 4, dessen ansteigende Flanke in der Figur 3 dargestellt ist, können somit mehrere zeitlich versetzte Impulse 7a, 7b, 7c und 7d erzeugt werden. Die Verzögerungszeit ist dabei durch den Strom im Referenzzweig des Stromspiegels einstellbar.

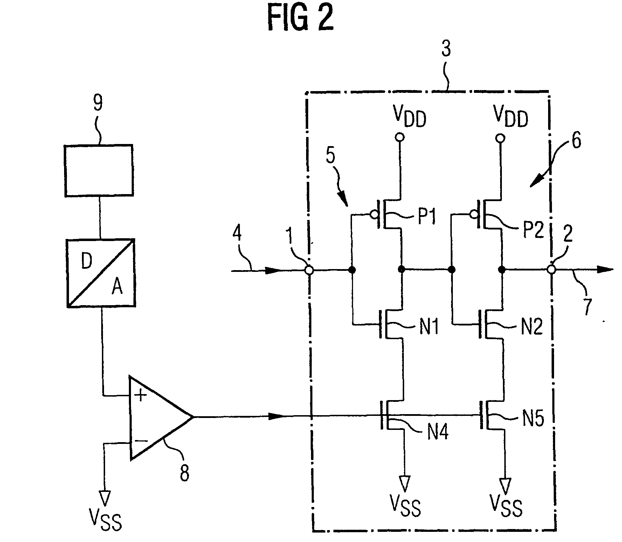

In vielen Anwendungsfällen werden in integrierten Schaltungen sicherheitsrelevante Daten gespeichert oder verarbeitet. Eine durch nicht berechtigte Personen oftmals angewandte Methode, um Zugriff auf diese Daten zu erhalten, ist die Messung der Stromaufnahme der Gesamtschaltung. Durch statistische Auswertungen kann eine Korrelation zwischen internen Vorgängen und dem äußeren Stromprofil festgestellt werden. In einem solchen Fall ist es vorteilhaft, die Strombegrenzungsvorrichtungen N4 und N5 (Figur 2) durch einen Zufallsgenerator 9 anzusteuern. Der Zufallsgenerator 9 ist dabei gemäß dem Ausführungsbeispiel von Figur 2 digital ausgeführt und steuert über einen zwischengeschalteten Digital-/Analogwandler D/A und einen Verstärker 8 die Transistoren N4 und N5 an. Je nach gewünschtem Sicherheitsgrad wird die Bandbreite der Streuung der Steuerspannung für die Transistoren N4 und N5 der Strombegrenzungvorrichtung ausgelegt.

In Figur 3 ist gezeigt, daß die Versorgungsspannung der Verzögerungsleitung 11 abgesenkt werden kann, während andere Schaltungsteile, die mit der Verzögerungsleitung 10 verwendet werden, mit der normalen Versorgungsspannung V_{DD} arbeiten. Die Spannungsabsenkung bei der Verzögerungsleitung 10 wird dadurch ermöglicht, daß nur zu V_{SS} hin begrenzt wird. Sie bringt mehrere Vorteile mit sich. Es kann nämlich eine gepufferte Referenzspannung V_{BG} verwendet werden, die beispielsweise auch für den Referenzzweig der Stromspiegel Anwendung findet. Dadurch reduziert sich der Temperatureinfluß und vor allem der Stromverbrauch.

Ein bevorzugtes Einsatzgebiet einer solchen Schaltung ist die Verwendung bei kontaktlosen Chipkarten. Gerade bei diesen ist eine Reduzierung des Stromverbrauches wichtig. Weiterhin wirken Spannungsschwankungen, welche auf kontaktlosen Chipkarten immer besonders stark vorzufinden sind, nicht auf die Verzögerungsleitung ein.

Durch das Absenken der Versorgungsspannung der Verzögerungsleitung 10 muß allerdings zu den mit der normalen Versorgungsspannung V_{DD} arbeitenden Schaltungsteilen ein sogenannter Levelshifter 4 vorgesehen werden, um die Logikpegel kompatibel zu machen. Der Levelshifter 4 enthält Pufferschaltkreise, die eine Belastung der Signalleitung zwischen den Verzögerungsgliedern 3 reduzieren.

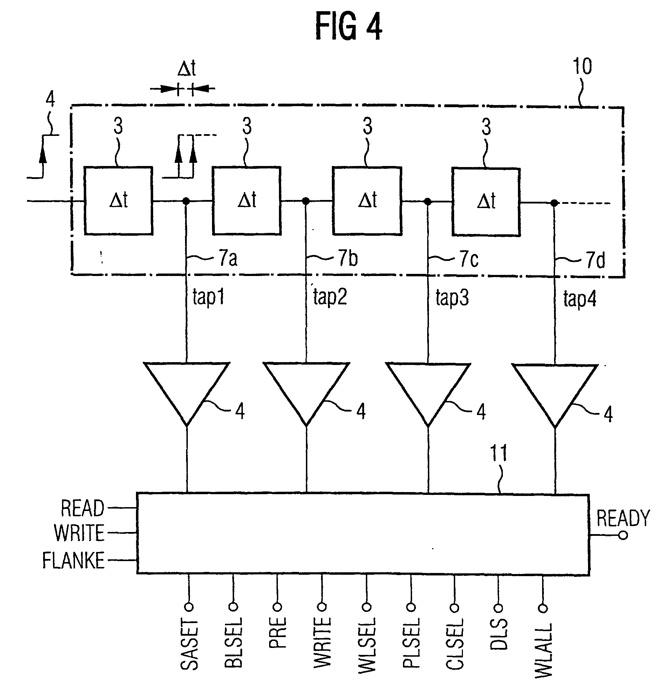

Wie bereits angesprochen, ist ein bevorzugtes Anwendungsgebiet der bisher beschriebenen Schaltung das Gebiet der kontaktlosen Chipkarten. Diese Chipkarten weisen in der Regel Speicherbausteine auf, deren Lese- und Schreibzyklen durch ein komplexes Timing-Diagramm gesteuert werden. Um die Leistungsfähigkeit der Speicherbausteine auszunutzen, ist eine sehr hohe Taktrate, beispielsweise 100 MHz, notwendig. Auf kontaktlosen Chipkarten gibt es zur Zeit jedoch eine Taktrate von maximal 13,56 MHz. Bestrebung ist sogar, diesen Takt noch weiter herunterzuteilen, um somit den Stromverbrauch weiter zu reduzieren. Durch eine Verzögerungsleitung 10, die gemäß der Erfindung aufgebaut und in Figur 4 dargestellt ist, kann auf einfache und stromsparende Weise aus einem verhältnismäßig langsamen Takt eine schnelle Folge von Impulsen generiert werden, die in Verbindung mit einer kombinatorischen Logik 11 zur Generierung von Ansteuersignalen für Speicherbausteine verwendet werden können. Die Levelshifter 4 passen die Logikpegel an und verhindern eine zu starke Belastung der Verzögerungsglieder. Trotz eines langsamen Taktes auf der Chipkarte ist somit die Ausschöpfung der vollen Leistungsfähigkeit von Speicherbausteinen möglich.

Ein weiteres Problem tritt vor allen Dingen bei sogenannten FeRAM-Speicherbausteinen in Erscheinung. Bei solchen Bausteinen kann es zum sogenannten "zerstörenden Lesen" kommen, wenn ein Taktsignal ausfällt. Dies ist bei kontaktlosen Chipkarten häufig ein Problem. Ein Taktausfall bei einem Lesezugriff auf den FeRAM-Baustein hätte einen Datenverlust zur Folge. Bei dem Einsatz einer erfindungsgemäßen Verzögerungsleitung wird ein Lese- oder Schreibvorgang jedoch immer vollständig abgearbeitet, da aus einem Impuls eines Taktgenerators sämtliche Impulse zur Steuerung des gesamten Schreib- oder Lesezyklus erzeugt werden.

Durch den geringen Stromverbrauch bei gemäß der Erfindung aufgebauten Verzögerungsgliedern 3 können beliebig viele solcher Verzögerungsglieder hintereinander geschaltet werden. Somit lassen sich auch komplexe Timing-Diagramme realisieren, während bei Verzögerung mit Kondensatoren der Stromverbrauch die Anzahl der Verzögerungsglieder beschränkt.

## Patentansprüche

1. Verzögerungsglied mit
- mindestens einem elektronischen Schalter (5, 6), an dessen Eingang (1) ein Eingangssignal (4) und an dessen Ausgang (2) ein Ausgangssignal (7) anliegt, und
- einer Strombegrenzungsvorrichtung (N4, N5), die die Stromaufnahme des mindestens einen elektronischen Schalters (5, 6) begrenzt, wobei durch die Begrenzung der Stromaufnahme des mindestens einen elektronischen Schalters (5, 6) die Schaltzeit verlangsamt ist.

2. Verzögerungsglied nach Anspruch 1,
**dadurch gekennzeichnet,daß**
die Strombegrenzungsvorrichtung (N4, N5) durch einen Stromspiegel gesteuert ist.

3. Verzögerungsglied nach Anspruch 1,
**dadurch gekennzeichnet,daß**
die Strombegrenzungsvorrichtung (N4, N5) durch einen Zufallsgenerator (9) gesteuert ist.

4. Verzögerungsglied nach Anspruch 1,
**dadurch gekennzeichnet, daß**
die Strombegrenzungsvorrichtung (N4, N5) zwischen dem mindestens einen elektronischen Schalter (5, 6) und einer Bezugsspannung (V_{SS}) angeordnet ist.

5. Verzögerungsglied nach Anspruch 1,
**dadurch gekennzeichnet, daß** der mindestens eine elektronische Schalter ein Inverter ist und zwei Inverter (5, 6) hintereinander geschaltet sind, wobei jeweils die Stromaufnahme begrenzt ist.

6. Verzögerungsglied nach Anspruch 1,
**dadurch gekennzeichnet, daß**
ein Referenzzweig des Stromspiegels mit einer Referenzspannung (V_{BG}) verbunden ist.

7. Verzögerungsglied nach Anspruch 6,
**dadurch gekennzeichnet, daß**
der Begrenzungswert der Strombegrenzungsvorrichtung (N4, N5) einstellbar ist.

8. Verzögerungsleitung,
**dadurch gekennzeichnet, daß**
mehrere Verzögerungsglieder (3) nach einem der Ansprüche 1 bis 7 hintereinander geschaltet sind.

9. Speicher-Ansteuervorrichtung mit einer Verzögerungsleitung (10) nach Anspruch 7 und einer Ansteuerschaltung (11) für einen Speicher, wobei Taktimpulse für die Ansteuerschaltung (11) durch Abgriff der Ausgangssignale (7a, 7b, 7c, 7d) der Verzögerungsglieder (3) der Verzögerungsleitung (10) bereitgestellt werden.

10. Speicher-Ansteuervorrichtung nach Anspruch 9,
**dadurch gekennzeichnet, daß**
die Verzögerungsleitung (10) mit einer stabilisierten Referenzspannung (V_{BG}) betrieben wird und die Ansteuerschaltung (11) Puffer und eine Vorrichtung zur Spannungsanhebung der Ausgangssignale (7a, 7b, 7c, 7d) der Verzögerungsglieder (3) auf die Versorgungsspannung (V_{DD}) aufweist.
